Europäisches Patentamt

European Patent Office

Office européen des brevets

(11) Numéro de publication: **0 298 874**

**A1**

## (12) DEMANDE DE BREVET EUROPEEN

(21) Numéro de dépôt: 88401803.7

(51) Int. Cl.⁴: **H 03 F 3/217**

(22) Date de dépôt: 11.07.88

(30) Priorité: 10.07.87 FR 8709861

(43) Date de publication de la demande:
11.01.89 Bulletin 89/02

(84) Etats contractants désignés:
AT BE CH DE ES FR GB GR IT LI LU NL SE

(71) Demandeur: ETABLISSEMENTS PAUL BOUYER & CIE
480 avenue de Paris
F-82002 Montauban (FR)

(72) Inventeur: Vilain, Jean-Paul
96 rue des Machemont Petit Melicocq
F-60150 Thourotte (FR)

Friedrich, Guy
Résidence "Les Arts" 45 rue Saint-Germain
F-60200 Compiègne (FR)

(74) Mandataire: Hammond, William et al
Cabinet CORRE & HAMMOND 17 rue Pasteur
F-92300 Levallois (FR)

(54) Procédé et dispositif de modulation d'impulsions.

(57) Le dispositif selon l'invention est destiné à moduler les impulsions d'un signal de sortie ($V_s$) à partir d'un signal d'entrée analogique ($V_e$) et comporte des moyens (3) pour générer un signal de différence entre une image du signal d'entrée et une image du signal de sortie, et des moyens pour commander un niveau du signal de sortie pour que le signal de différence ait une valeur moyenne nulle.

Fig.1

## Description

## Procédé et dispositif de modulation d'impulsions

La présente invention concerne un procédé et un dispositif de modulcation d'impulsions, notamment, bien que non exclusivement, pour l'amplification à découpage d'une tension dans une gamme de puissance assez vaste.

Dans les premiers dispositifs d'amplification d'une tension par des transistors, on a recherché à utiliser les transistors en régime linéaire. De tels amplificateurs ont un très faible rendement et une grande partie de la puissance fournie à l'appareil est donc perdue. De plus, la puissance perdue doit être dissipée. Les amplificateurs utilisant des transistors en régime linéaire sont donc d'autant plus encombrants et d'autant plus lourds qu'il est nécessaire d'une part de fournir une forte puissance en particulier au niveau du transformateur d'alimentation et d'autre part de prévoir des radiateurs de grandes dimensions permettant l'élimination de la puissance perdue.

Afin de pallier ces inconvénients, on a déjà réalisé des amplificateurs à découpage dans lesquels les transistors sont utilisés comme de simples interrupteurs. Le signal de sortie se présente sous la forme d'une série d'impulsions d'amplitude constante dont la largeur est fonction du signal d'entrée. Selon un procédé dit d'échantillonnage naturel, le signal d'entrée est comparé à une onde porteuse triangulaire et le signal de sortie est commuté chaque fois qu'il y a une intersection entre l'onde porteuse et le signal d'entrée. On a constaté toutefois que si le rapport de la fréquence de l'onde porteuse à celle du signal d'entrée est inférieur à 10, il apparaît dans la tension de sortie des sous-harmoniques qui sont incompatibles avec certaines utilisations, notamment dans le domaine de la reproduction des sons. Par ailleurs, le maintien d'un rapport de 10 entre la fréquence de l'onde porteuse et la fréquence du signal d'entrée entraîne une fréquence de commutation très élevée des transistors et donc une fatigue de ceux-ci.

Un but de la présente invention est de proposer un procédé et un dispositif de modulation d'impulsions nécessitant un nombre de commutations inférieur à celui des procédés et dispositifs existant actuellement tout en assurant une bonne qualité du signal de sortie obtenu.

En vue de la réalisation de ce but, on prévoit selon l'invention un procédé de modulation d'impulsions d'un signal de sortie à partir d'un signal d'entrée analogique caractérisé en ce qu'il comporte les étapes de générer un signal de différence entre le signal d'entrée, ou une image de celui-ci, et le signal de sortie, où une image de celui-ci ayant une amplitude supérieure à une amplitude maximale du signal d'entrée ou de son image, et commander un niveau du signal de sortie pour que le signal de différence ait une valeur moyenne nulle.

Ainsi, on évite une divergence du signal de différence et le signal de sortie suit, en moyenne, des variations semblables à celles du signal d'entrée. En outre, la fréquence de commutation du signal de sortie n'est pas directement liée à celle du signal d'entrée.

Selon une version avantageuse de l'invention, l'étape de commander le niveau du signal de sortie comprend les étapes de calculer une intégrale dans le temps du signal de différence et de modifier le niveau du signal de sortie lorsque l'intégrale du signal de différence atteint l'un d'au moins deux seuils choisis. Ainsi, la fréquence de commutation du signal de sortie dépend en grande partie de la constante de temps de l'intégrale du signal de différence et on peut donc choisir à volonté la fréquence de commutation la plus appropriée.

Selon un mode particulier de mise en oeuvre du procédé selon l'invention, le signal de sortie comporte deux niveau de même amplitude et de signes opposés, l'intégrale du signal de différence est comparée à deux seuils de même amplitude et de signes opposés, et le signe du signal de sortie est modifié chaque fois que l'intégrale du signal de différence atteint l'un des seuil. Ainsi, le procédé selon l'invention est mis en oeuvre de façon particulièrement simple.

Selon un autre mode de mise en oeuvre de l'invention, le signal de sortie comporte deux niveaux de même amplitude et de signes opposés et un niveau nul, l'intégrale du signal de différence comporte une première paire de seuils ayant une première amplitude commune et des signes opposés et une seconde paire de seuils ayant une seconde amplitude, supérieure à la première amplitude, et des signes opposés, et le niveau de sortie est mis au niveau nul lorsque l'intégrale du signal de différence atteint l'un des seuils de la première paire de seuils et a un niveau d'amplitude non nul de même signe que l'intégrale du signal de différence lorsque celle-ci atteint l'un des seuils de la seconde paire de seuils.

Ainsi, on minimise encore la fréquence de commutation, et donc la fatique, des organes assurant cette commutation.

Selon encore un autre aspect de l'invention, on prévoit un dispositif de modulation d'impulsions d'un signal de sortie à partir d'un signal d'entrée analogique comportant des moyens pour générer un signal de différence entre le signal d'entrée, ou une image de celui-ci, et le signal de sortie, ou une image de celui-ci ayant une amplitude supérieure à une amplitude maximale du signal d'entrée ou de son image, et des moyens pour commander un niveau du signal de sortie pour que le signal de différence ait une valeur moyenne nulle.

De préférence, les moyens pour commander le niveau du signal de sortie comprennent des moyens pour calculer une intégrale dans le temps du signal de différence, et des moyens pour modifier le niveau du signal de sortie lorsque l'intégrale du signal de différence atteint l'un d'au moins deux seuils choisis.

Selon un mode de réalisation préféré, les moyens pour modifier le niveau du signal de sortie comportent quatre interrupteurs disposés selon les côtés d'un pont ayant une diagonale comportant un organe d'alimentation et une autre diagonale aux bornes de laquelle est prélevé le signal de sortie.

D'autres caractéristiques et avantages de l'invention apparaîtront à la lumière de la description qui suit de modes de mise en oeuvre ou de réalisation particuliers non limitatifs de l'invention en liaison avec les dessins ci-joints parmi lesquels:

    - la figure 1 est un diagramme par blocs d'un premier mode de réalisation de dispositif de mise en oeuvre du procédé selon l'invention,

    - la figure 2 est un graphique illustrant le profil des images des tensions d'entrée et de sortie en fonction du temps.

    - la figure 3 est un graphique illustrant les variations de la différence entre l'image de la tension d'ent... et l'image de la tension de sortie au cours du temps,

    - la figure 4 est un graphique illustrant des variations de l'intégrale du signal de différence au cours du temps.

    - la figure 5 est un diagramme schématique illustrant la commande du signal de sortie en fonction de l'intégrale du signal de différence,

    - la figure 6 est un diagramme schématique illustrant le dispositif de commutation de puissance modifiant le niveau du signal de sortie,

    - la figure 7 est un diagramme analogue à celui de la figure 5 pour un autre mode de mise en oeuvre de l'invention,

    - la figure 8 est un diagramme par bloc analogue à celui de la figure 1 illustrant un autre mode de réalisation de l'invention.

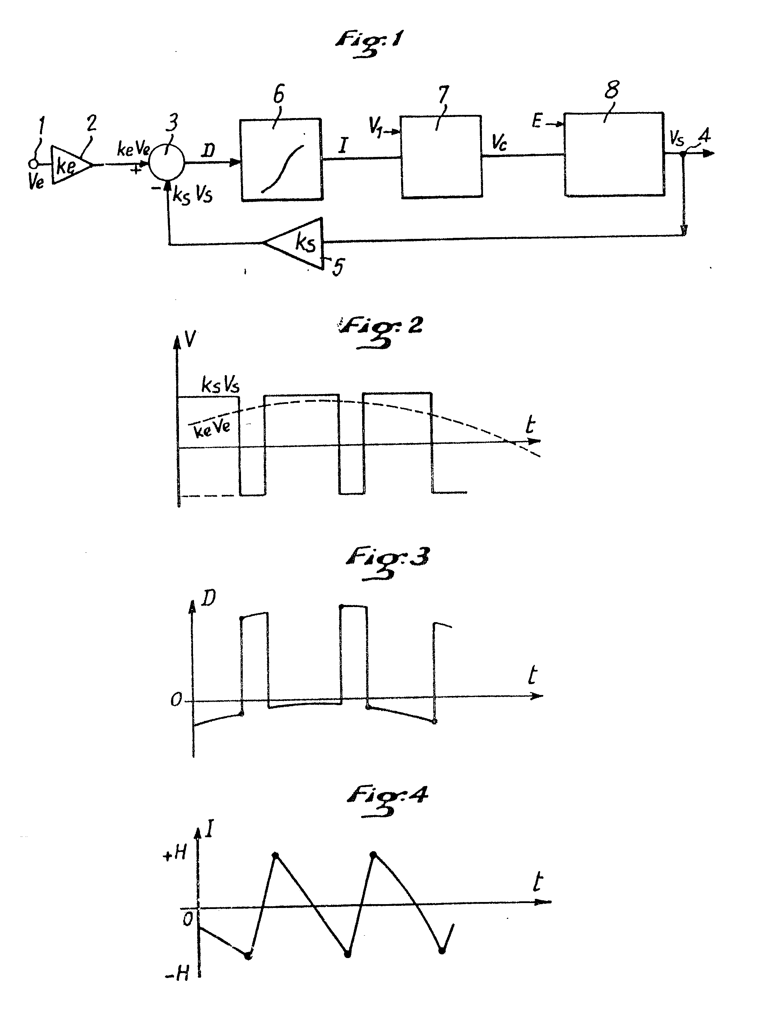

En référence à la figure 1, le dispositif illustré comporte une borne d'entrée 1 sur laquelle est appliqué un signal d'entrée $V_e$. Un amplificateur 2, de gain $k_e$, a son entrée reliée à la borne d'entrée 1 et sa sortie reliée à une borne d'entrée directe d'un additionneur 3 ayant une borne d'entrée inverse reliée à une borne de sortie 4 par une ligne comportant un atténuateur 5 de coefficient d'atténuation $k_s$. La borne de sortie de l'additionneur 3 est reliée à la borne d'entrée d'un intégrateur 6 dont la borne de sortie est reliée à un dispositif de commande 7 qui reçoit par ailleurs une tension d'alimentation $V_1$. La borne de sortie du dispositif de commande 7 est reliée à une borne d'entrée d'un dispositif de commutation de puissance 8 qui reçoit par ailleurs une tension d'alimentation E.

Le dispositif selon l'invention est principalement destiné à assurer une amplification du signal d'entrée $V_e$. Le signal de sortie $V_s$ est donc généralement très supérieur au signal d'entrée. L'amplificateur 2 et l'atténuateur 5 ont donc principalement pour fonction de réaliser des images, respectivement des signaux d'entrée et de sortie, qui soient sensiblement du même ordre de grandeur afin que le signal de différence D recueilli à la sortie de l'additionneur 3 soit à un niveau compatible avec les caractéristiques d'entrée de l'intégrateur 6.

Le procédé est destiné à moduler des impulsions du signal de sortie $V_s$ dont l'amplitude est de préférence maintenue constante à un niveau $\pm E$, la valeur moyenne du signal de sortie $V_s$ étant finalement déterminée par le signe et la durée des impulsions.

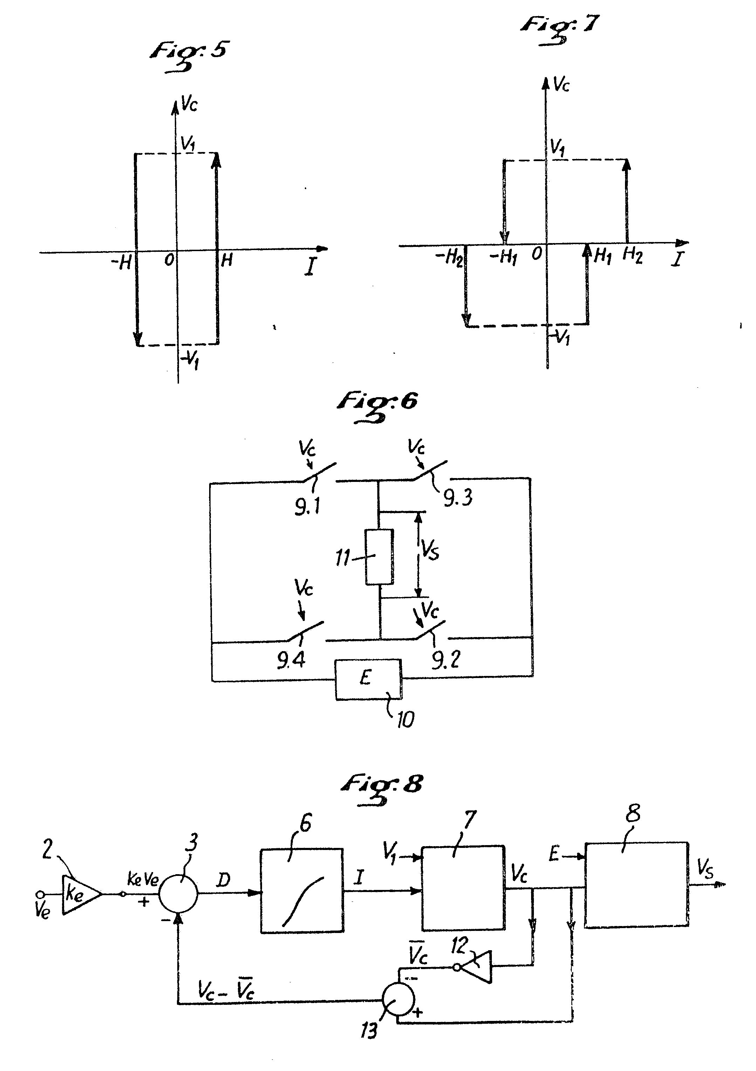

La figure 5 illustre la commande de la tension de commande $V_c$ en fonction du niveau du signal I recueilli à la sortie de l'intégrateur 6, pour un premier mode de mise en oeuvre de l'invention dans lequel le signal de sortie $V_s$ comporte deux niveaux de même amplitude E et de signes opposés tandis que l'intégrale I du signal de différence D est comparée à deux seuils de même amplitude H et de signes opposés. On constate sur la figure 5 que chaque fois que la valeur de l'intégrale I atteint le niveau H, on fait passer la tension de commande $V_c$ de la valeur $-V_1$ à la valeur $V_1$ et chaque fois que l'intégrale I atteint la valeur $-H$, on fait passer la tension de commande $V_c$ de la valeur $V_1$ à la valeur $-V_1$.

La tension de commande $V_c$ sert à commander le dispositif de commutation 8 qui, selon un mode de réalisation préféré de l'invention illustré par la figure 6, comporte quatre transistors 9.1, 9.2, 9.3 et 9.4 montés en interrupteurs et disposés selon un pont dont une des diagonales comporte un organe d'alimentation 10 délivrant la tension E et l'autre diagonale comporte une charge 11 aux bornes de laquelle est prélevé le signal de sortie $V_s$. Les transistors - interrupteurs 9.1 et 9.2 sont commandés par la tension de commande $V_c$ pour être conducteurs lorsque la tension $V_c$ est égale à $V_1$ et pour être bloqués lorsque la tension $V_c$ est égale à $-V_1$, tandis que les transistors - interrupteurs 9.3 et 9.4 sont commandés pour être bloqués lorsque la tension de commande est $V_1$ et conducteurs lorsque la tension de commande est $-V_1$. Ainsi, la tension de sortie $V_s$ recueillie aux bornes de la charge 11 est $+E$ ou $-E$ suivant que la tension de commande est respectivement $+V_1$ ou $-V_1$. A ce propos, on remarquera que le signal de différence D n'est pas nécessairement l'image directe de la tension de sortie $V_s$ mais peut être une tension assimilée. En particulier, dans l'exemple qui vient d'être décrit, la tension $V_c$ est tout-à-fait représentative du signal de sortie et peut être renvoyée directement à l'entrée de l'additionneur 3. De même, si la tension de commande est un signal logique variant entre un niveau 0 et un niveau $V_1$, la borne d'entrée inverse de l'additionneur 3 peut être reliée à la tension de commande, comme illustré par la figure 8, au moyen d'un circuit comportant un inverseur 12 et un additionneur 13 de sorte que le signal $V_c$ - $\overline{V}_c$ apparaissant à l'entrée inverse de l'additionneur 3 évoluera entre deux niveaux de même amplitude et de signes opposés qui sont directement proportionnels à la tension de sortie et en constituent donc l'image.

Les figures 2 à 4 illustrent les différents profils de signaux obtenus lors de la mise en oeuvre du premier mode de réalisation de l'invention. La figure 2 illustre en pointillé l'image du signal du signal d'entrée et en continu l'image du signal de sortie en fonction du temps. On constate que le signal d'entrée analogique est converti en impulsions. On remarquera à ce propos que pour une mise en oeuvre stable du procédé selon l'invention, il est nécessaire que l'image du signal de sortie ait une amplitude supérieure à l'amplitude maximale de l'image du signal d'entrée faute de quoi le basculement de la tension de sortie d'un signe à l'autre risque de ne pas modifier le sens de l'évolution de l'intégrale du signal de différence. Lorsque cette condition est respectée, on remarque, comme illustré par la figure 3 qui représente le profil du signal de différence en fonction du temps, que le signal de différence est alternativement positif et négatif de sorte que le signal de l'intégrale du signal de différence est lui-même alternativement croissant et décroissant comme illustré par la figure 4.

La figure 7 illustre les changements de niveau de la tension de commande en fonction de l'intégrale dans le temps du signal de différence pour un autre mode de réalisation de l'invention dans lequel le signal de commande et le signal de sortie varient entre deux niveaux d'amplitude non nuls et de signes opposés, et un niveau nul. Dans ce cas, l'intégrale du signal de différence comporte une première paire de seuils ayant une première amplitude commune $H_1$ et des signes opposés, et une seconde paire de seuils ayant une seconde amplitude commune $H_2$ supérieure à la première amplitude $H_1$ et des signes opposés. Le dispositif de commande 7 est cette fois réalisé pour que le signal de commande passe au niveau $V_1$ lorsque l'intégrale du signal de différence atteint le seuil $+H_2$, le signal de commande passe au niveau 0 lorsque l'intégrale du signal de différence atteint le seuil $+H_1$ ou $-H_1$, et le signal de commande passe au niveau $-V_1$ lorsque l'intégrale du signal de différence atteint le seuil $-H_2$. Simultanément, les transistors-interrupteurs 9.1 et 9.2 sont montés pour conduire lorsque la tension de commande est égale à $+V_1$, les transistors-interrupteurs 9.3 et 9.4 sont montés pour être conducteurs lorsque la tension de commande est $-V_1$, et les transistors 9.2 et 9.3 sont montés pour être conducteurs lorsque la tension de commande est nulle tandis que les transistors 9.1 et 9.4 sont bloqués. Ainsi, la tension de sortie sera au niveau $+E$ lorsque la tension de commande sera au niveau $+V_1$, au niveau 0 lorsque la tension de commande sera au niveau 0, et au niveau $-E$ lorsque la tension de commande sera au niveau $-V_1$. On constate que ce mode de réalisation nécessite la commutation de deux transistors seulement au lieu de quatre à chaque changement de niveau du signal de sortie de sorte que le nombre de commutations est diminué et les transistors sont donc soumis à une contrainte moins importante.

Bien entendu l'invention est susceptible de variantes de réalisation qui apparaîtront à l'homme de métier sans sortir du cadre de l'invention. En particulier, on comprendra que le nombre de seuils décrits n'est pas limitatif et pourra être adapté à un application particulière.

Le procédé et le dispositif selon l'invention s'avèrent particulièrement intéressants pour l'amplification des sons sans distorsion, ils sont également avantageux dans le domaine électro-technique et dans le domaine des télécommunications. A ce propos, on remarquera que l'intégrateur 6 n'est pas nécessairement un intégrateur parfait. Pour certaines applications, notamment lorsque le dispositif est destiné à fonctionner avec des tensions d'entrée de fréquence déterminée, on pourra remplacer l'intégrateur par un circuit du type RC ou LR dont la constante de temps peut être liée à celle de la charge de l'amplificateur.

## Revendications

1. Procédé de modulation d'impulsions d'un signal de sortie ($V_s$) à partir d'un signal d'entrée analogique ($V_e$) caractérisé en ce qu'il comporte les étapes de générer un signal de différence (D) entre le signal d'entrée, ou une image de celui-ci, et le signal de sortie, ou une image de celui-ci ayant une amplitude supérieure à une amplitude maximale du signal d'entrée ou de son image, et commander un niveau du signal de sortie ($V_s$) pour que le signal de différence (D) ait une valeur moyenne nulle.

2. Procédé de modulation d'impulsions selon la revendication 1 caractérisé en ce que l'étape de commander le niveau du signal de sortie comprend les étapes de calculer une intégrale dans le temps (I) du signal de différence (D) et de modifier le niveau du signal de sortie ($V_s$) lorsque l'intégrale du signal de différence atteint l'un d'au moins deux seuils choisis.

3. Procédé de modulation d'impulsions selon la revendication 2 dans lequel le signal de sortie ($V_s$) comporte deux niveaux ($+E$, $-E$) de même amplitude et de signes opposés caractérisé en ce que l'intégrale du signal de différence est comparée à deux seuils ($+H$, $-H$) de même amplitude et de signes opposés et en ce que le signe du signal de sortie est modifié chaque fois que l'intégrale du signal de différence atteint l'un des seuils.

4. Procédé de modulation d'impulsions selon la revendication 2, caractérisé en ce que le signal de sortie comporte deux niveaux ($+E$, $-E$) de même amplitude et de signes opposés et un niveau nul, en ce que l'intégrale du signal de différence est comparée à une première paire de seuils ($+H_1$, $-H_1$) ayant une première amplitude commune et des signes opposés et une seconde paire de seuils ($+H_2$, $-H_2$) ayant une second amplitude, supérieure à la première amplitude, et des signes opposés, et en ce que le signal de sortie est mis au niveau nul lorsque l'intégrale du signal de différence atteint l'un des seuils de la première paire de seuils et à un niveau d'amplitude non nul de même signe que l'intégrale du signal de différence lorsque celle-ci atteint l'un des seuils de la seconde paire de seuils.

5. Dispositif de modulation d'impulsions d'un signal de sortie à partir d'un signal d'entrée analogique caractérisé en ce qu'il comporte des moyens (3) pour générer un signal de différence (D) entre le signal d'entrée ($V_e$), ou une image de celui-ci, et le signal de sortie ($V_s$), ou une image de celui-ci ayant une amplitude supérieure à une amplitude maximale du signal d'entrée ou de son image, et des moyens (7, 8) pour commander un niveau du signal de sortie pour que le signal de différence ait une valeur moyenne nulle.

6. Dispositif de modulation d'impulsions selon la revendication 5, caractérisé en ce que les moyens pour commander le niveau du signal de sortie comprennent des moyens (6) pour calculer une intégrale dans le temps du signal de différence (D), et des moyens (7, 8) pour modifier le niveau du signal de sortie chaque fois que l'intégrale du signal de différence atteint l'un d'au moins deux seuils choisi.

7. Dispositif de modulation d'impulsions selon la revendication 6, caractérisé en ce que les moyens pour modifier le niveau du signal de sortie comportent quatre interrupteurs (9.1 - 9.4) disposés selon les côtés d'un pont ayant une diagonale comportant un organe d'alimentation (10) et une autre diagonale aux bornes de laquelle est prélevé le signal de sortie $(V_s)$.

0298874

Fig.1

Fig.2

Fig.3

Fig.4

**Fig. 5**

**Fig. 7**

**Fig. 6**

**Fig. 8**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | INSTRUMENTS AND EXPERIMENTAL TECHNIQUES, vol. 19, no. 5, partie 1, septembre-octobre 1976, pages 1415-1417; V.A. KLYNIN: "Direct-current amplifier with frequency-pulse-width modulation" * En entier * | 1-3,5,6 | H 03 F   3/217 |
| X | GB-A-1 239 922  (K.D.G. INSTRUMENTS LTD) * Figures 4-6A; page 3, lignes 22-38 * | 1-3,5,6 | |
| A | DE-A-2 542 171  (C.L. STURGEON) * Figures 2-4; page 9, lignes 14-32 * | 4 | |
| A | EP-A-0 211 210  (LICENTIA PATENT-VERWALTUNGS-GmbH) * Figure 1; résumé * | 7 | |
| | | | DOMAINES TECHNIQUES RECHERCHES (Int. Cl.4) |
| | | | H 03 F |

Le présent rapport a été établi pour toutes les revendications

| Lieu de la recherche | Date d'achèvement de la recherche | Examinateur |
|---|---|---|
| LA HAYE | 23-09-1988 | TYBERGHIEN G.M.P. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.........................................................
& : membre de la même famille, document correspondant

EPO FORM 1503 03.82 (P0402)